# NEW EUROPEAN PATENT SPECIFICATION

(11) **EP 0 291 597 B2**
(45) Date of publication and mention of the opposition decision: **03.01.1996**
(45) Mention of the grant of the patent: 19.08.1992
(21) Application number: 87304616.3
(22) Date of filing: 22.05.1987
(51) Int. Cl.: E04B 1/92

(54) **Method of electromagnetically shielding a building**
Verfahren zum elektromagnetischen Abschirmen von Gebäuden
Procédé pour la blindage électromagnétique des bâtiments

(43) Date of publication of application: 23.11.1988
(73) Proprietor: SHIMIZU CONSTRUCTION Co. LTD., Chuo-ku Tokyo 104 (JP)
(72) Inventor: Takahashi, Takeshi, Chuo-ku Tokyo 104 (JP); Ishikawa, Toshiyuki, Chuo-ku Tokyo 104 (JP); Nakamura, Masatake, Chuo-ku Tokyo 104 (JP); Nagata, Koji, Chuo-ku Tokyo 104 (JP); Yabana, Yoshiji, Chuo-ku Tokyo 104 (JP)
(74) Representative: Bubb, Antony John Allen

(56) References cited:
- EP-A- 0 291 592
- DE-A- 2 251 440
- DE-U- 8 429 855
- US-A- 3 323 063
- US-A- 4 590 710
- PATENT ABSTRACTS OF JAPAN, vol. 9. no. 69, (E-305)[1792], 29th March 1985
- PATENT ABSTRACTS OF JAPAN, vol. 7, no. 123 (E-178)[1268], 27th May 1983

## Description

This invention relates to a method of shielding a building by providing an electromagnetic shield structure so as to shield an information network system utilizing electric waves, and more particularly for enhancing the electromagnetic shielding performance of an external wall.

In many modern buildings, information generally is communicated between the interior and the outside of the building by making joint use of information communicating equipment such as multiple electronic exchanges and computers. With the increasing value of information, diversification of user needs and increasingly individual nature thereof, the amount of information involved in such communication is growing. Under these circumstances, how to transmit the necessary information rapidly and at low cost where large-scale buildings are involved has become of prime importance. In an effect to satisfy this need, data highway-type information networks utilizing optical fiber cables or coaxial cables have been studied and proposed.

However, with a data highway system utilizing optical fiber cables or coaxial cables, the cables must be stretched throughout all parts of the building to reach the various pieces of communication equipment. Extra time is needed to complete the work and additional expenses are required to lay these cables.

If electric waves are used to transmit information within the building, laying cables is unnecessary but the radio waves are limited to a certain range owing to the emission of electrical noise waves from such a building. Another problem is that the communication system may malfunction due to electric waves from outside the building, television intermediate frequencies from inside the building, electric waves from wireless microphones, and the like.

It is known from the abstract of JP-A-59205834 to provide a building having outer walls made of concrete shielding which may have a glass surface layer, to shield radio equipment within the building.

DE-A-2251440 describes electromagnetic shielding of buildings by layers of metal, steel mesh, and the provision of water or solutions for dampening of concrete to increase its conductivity.

An object of the present invention is to provide a method of electromagnetic shielding a building so that information can be communicated therein using electric means of any frequency over a wide range of frequencies.

In accordance with the invention we provide a method of electromagnetically shielding a building which contains equipment for communication within said building and a signal transmission medium so arranged that sets of said communication equipment communicate with one another within said building by using electric waves in which an outer peripheral portion of said building is constituted by an electromagnetic shielding structure obtained by constructing an external wall by fixing a curtain wall comprising electromagnetic shielding material to the body of the building by an anchor bolt via a metal fastener, affixing an electrically conductive cushion to a side face of said curtain wall, and electrically integrating mutually adjacent curtain walls, whereby at least a part of the interior of the building is electromagnetically shielded.

In one embodiment the external wall of a building is constructed of PC panels having an imbedded mesh, the mesh in the PC panels is electrically connected to fixing members of the building body, and the PC panels of upper and lower floors are electrically connected and grounded. Alternatively, use is made of curtain walls constructed of electromagnetic shielding members and fixed to the body of a building by anchor bolts via metal fasteners. Electrically conductive cushions are affixed to the side faces of the curtain walls, and neighboring curtain walls are electrically integrated to form an electromagnetic shielding space. The communication system includes a coaxial cable laid so as to pass through the floors of the building, leakage coaxial cables stretched along the ceiling of each floor and connected via to the coaxial cable branching devices, and antennas. These cables and antennas are employed as a transmitting medium to permit communication within the building by utilizing electric waves.

In accordance with the above-described arrangements, the invention blocks electric waves at the body of the building by the formation of an electromagnetic shield. As a result, electric waves will not leak from the building even if information is communicated within the building using any desired frequency over a wide frequency band. In addition, communication equipment within the building will not malfunction due to electric waves penetrating the building from outside. When the mesh is imbedded in the PC panels, the meshes are electrically connected to the fixing members of the building body and the PC panels of upper and lower floors are electrically interconnected and grounded, an electromagnetic shielding effect can be obtained at the external wall of the building through simple construction work.

If the curtain wall is adopted as the external wall, a curtain wall having an electromagnetic shielding function is used and the electrically conductive cushion is affixed to the side face of the curtain wall. Then, by securing the curtain wall to the body of the building by the anchor bolts via the metal fasteners, mutually adjacent curtain walls can be electrically integrated. By adopting this arrangement, the external wall can be assembled through the conventional method, i.e. by securing the curtain walls to the metal fasteners by the anchor bolts and then assembling the external wall, at the same time that the entirety of the external wall is furnished with the electromagnetic shielding property.

In the communication system, the leakage coaxial cables stretched along the ceiling of each floor serve as antennas and the antennas are interconnected by a coaxial cable via branching devices. As a result, electric wave signals emitted by the communication equipment on each floor are transmitted by the antennas of the leakage coaxial cables and received by the communication equipment on other floors through the antennas of the leakage coaxial cables on these other floors.

In the accompanying drawings:
Fig. 1 is a view for describing an embodiment of a building the body of which is electromagnetically shielded in accordance with the present invention;
Figs. 2A and 2B are views for describing an embodiment of another electromagnetic shielding method according to the present invention; and
Fig. 3 is a view illustrating an embodiment of the electromagnetic shielding structure of an external wall using a curtain wall in accordance with the present invention.

Embodiments of the invention will now be described with reference to the drawings.

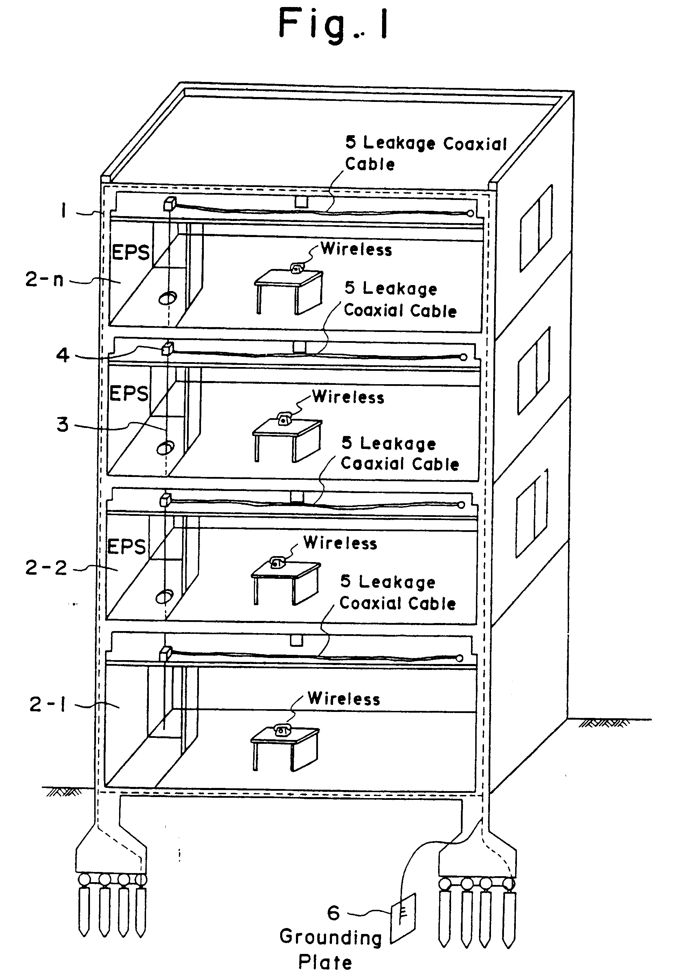

As shown in Fig. 1, a building in accordance with the invention includes a body 1, pipe shafts 2-1 through 2-n for electrical equipment (each pipe shaft being referred to as an EPS hereinafter), a coaxial cable 3, branching devices 4, leakage coaxial cables 5, and a grounding plate 6.

In the building shown in Fig. 1, the body 1 is electromagnetically shielded, as indicated by the dashed line in Fig. 1, in such a manner that electric waves from communications equipment will not leak from the building. The leakage coaxial cables 5 are stretched along each floor and are connected to the coaxial cable 3 via the branching devices 4. By using electric waves transmitted through these cables, communication is possible among communications equipment installed on each floor without requiring that cables be laid to interconnect the equipment. In particular, if the entirety of the building body 1 is furnished with an electromagnetic shielding capability, the transmission and reception of electric waves between upper and lower floors will be blocked by the body 1. For this reason, the leakage coaxial cables 5 are provided to perform a relay function on each floor. A community television cable ordinarily used in buildings can be employed as the coaxial cable 3, which is passed through the EPSs 2-1 through 2-n. Though not shown, a community antenna is connected to the head end of the coaxial cable 3, and television receivers or the like are connected to the coaxial cable 3 via the branching devices 4. Accordingly, a signal received from the community antenna is distributed by the branching devices 4 via the head end and coaxial cable 3.

In accordance with the invention, the emission of electrical noise to the exterior of the building is eliminated by electromagnetically shielding the body 1. Therefore, merely stretching the leakage coaxial cables 5 along the ceiling of each floor as antennas and connecting them to the branching devices 4 makes it possible to freely use even electric waves in a frequency band subjected to restrictions in accordance with law, thus enabling these electric waves to be used for the communication of information within the building. The invention thus makes it possible to employ electric waves of any economical, convenient easy-to-use frequency band.

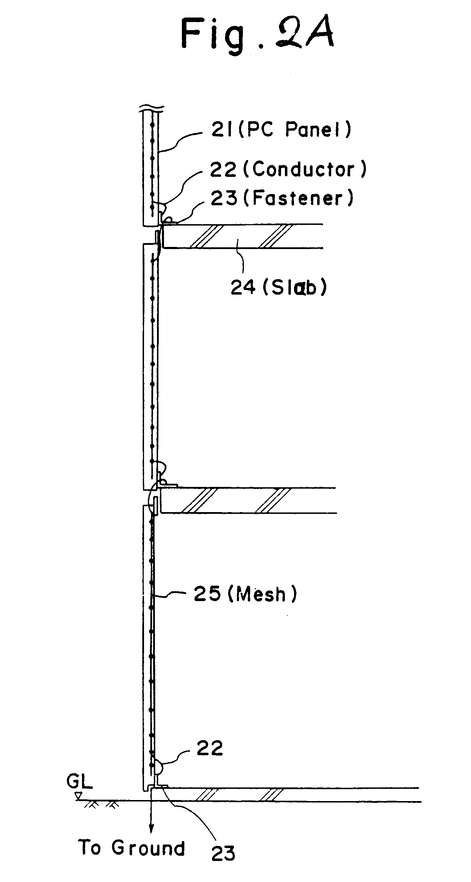

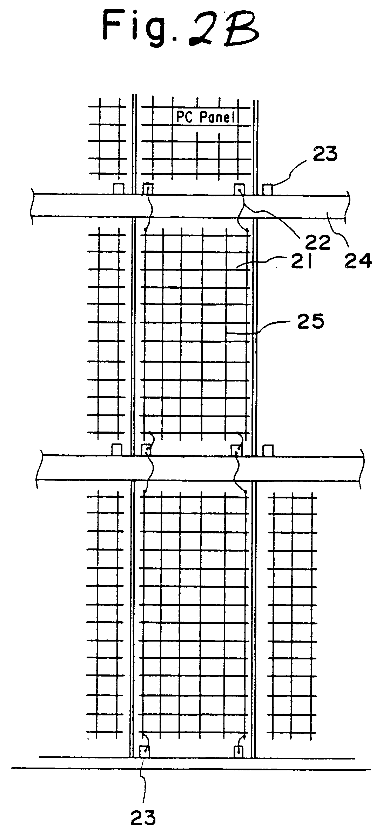

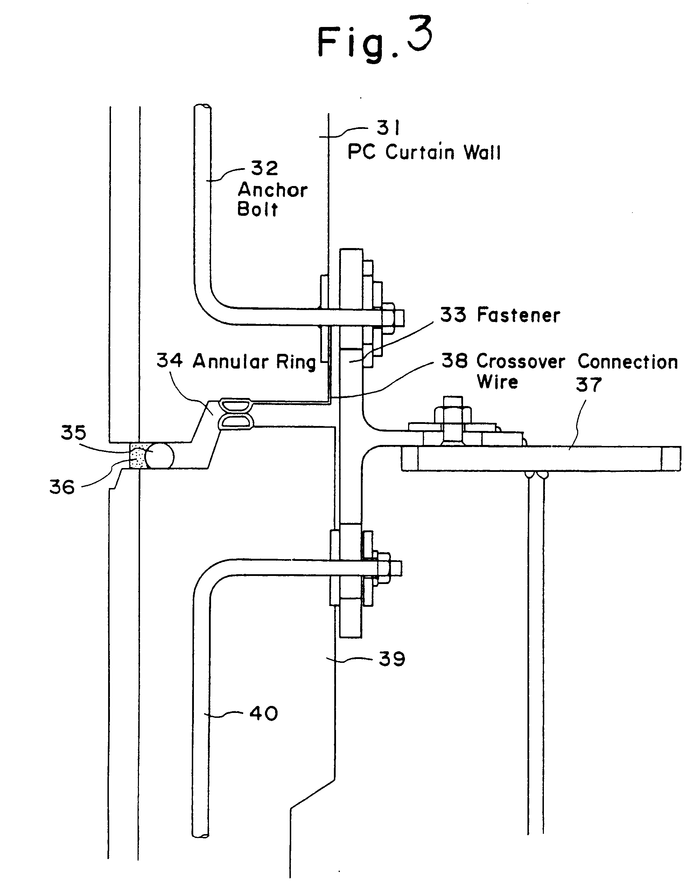

Figs. 2A and 2B are views for describing an embodiment of another method of electromagnetically shielding a building, in which 21 represents a PC (precast concrete) panel, 22 a conductor, 23 a fastener, 24 a slab and 25 a mesh.

In Figs. 2A and 2B, the mesh 25 having the conductor 22 led out therefrom is embedded in the PC panel 21, which is attached to the slab 24 by a fastener 23. When the PC panel 21 is attached to the slab 24, the conductor 22 is connected to the fastener 23, and the meshes 25 in PC panels 21 of the upper and lower floors are electrically interconnected via the fasteners 23. By grounding the mesh 25 in the PC panel 21 on the lowermost floor, all of the meshes 25 in the PC panels 21 covering the building are grounded to improve the electromagnetic shielding performance of the building.

In addition to the above embodiments, it is of course possible to provide an external wall with an electromagnetic shielding structure in accordance with the invention. For example, if a curtain wall is used as the external wall, the prior-art structure is such that cushion (an annular ring) is attached to the side face of a conventional curtain wall, a curtain wall edge portion is placed on the cushion, and this is fastened by securing anchor bolts to fasteners fixed to the building body side. Therefore, mutually adjacent curtain walls will not be electrically integrated merely by constructing an external wall of curtain walls using electromagnetic shielding members, and electric waves will leak from the gaps between the curtain walls. Thus, the overall external wall will have a very poor electromagnetic shielding effect. An example of an electromagnetic shielding structure capable of solving this problem will now be described.

Fig. 3 is a view showing an embodiment of an electromagnetic shielding structure of an external wall using a curtain wall for a building in accordance with the invention. Numerals 31, 39 denote PC curtain walls, 32, 40 anchor bolts, 33 a fastener, 34 an annular ring, 35 a back-up member, 36 a caulking material, 37 the beam of a steel frame, and 38 a crossover connecting wire.

Fig. 3 shows a transverse section of the connection between an upper-side PC curtain wall 31 and a lower-side curtain wall 39. In the external wall structure using the PC curtains walls shown in Fig. 3, the fastener 33 is secured to the steel frame beam 37, and the PC curtain walls 31, 39 are fixed to the fastener 33 by anchor bolts 32, 40. By securing the PC curtain walls 31, 39 to the fastener 33 with the annular ring 34 affixed to the side face of the PC curtain walls 31, 39, the gap between the panels is closed by the annular ring wound on the side face, as illustrated. A gap near the surface of the external wall is filled with the back-up member 35 and with the caulking material 36 disposed on the back-up member.

In the electromagnetic shielding structure of an external wall using a curtain wall in accordance with the invention, electromagnetic shielding members are used in the PC curtain walls 31, 39, the main body is made an electromagnetic shielding layer, and an electrically conductive cushion is used as the annular ring 34. In a case where the PC curtain wall has the annular ring 34 affixed to the side face with an electrical insulator layer interposed therebetween, the annular ring 34 and anchor bolt 32 are connected using the crossover wire 38, thereby electrically integrating the electromagnetic shielding layers on the main bodies of the PC curtain walls 31, 39 at the anchor bolts 32, 40 and fastener 33. The annular ring 34 is electrically integrated with the anchor bolt 32 by the crossover wire 38. An electrically integrated structure is obtained by using an electromagnetic shielding member as the back-up member 35.

Since the annular ring is wound on the side face of the PC curtain walls, a gap at the joint of the left and right PC curtain walls is closed by an annular ring, back-up member and caulking material, just as shown in Fig. 3, in order to obtain an electrically integrated structure.

By thus providing the periphery of a building with an electromagnetic shielding structure as set forth above, the communication of information utilizing electric waves can be carried out freely within the building.

In the system using the branch devices shown in Fig. 1, the branch devices connected to the community coaxial cable possess reverse-connection loss in order to reduce interference among one another. More specifically, owing to reverse-connection loss, signals flow between the head end and each set of equipment, but signals do not readily flow between one set of equipment and another. Ordinarily, reverse-connection loss is set in accordance with the FM or television frequency band of 80 MHz or greater for community use and is effective for high frequencies of 10 MHz or more.

In a case where a frequency band of the coaxial cable other than the FM or television frequency band is adopted for the communication line, there will be a frequency band in which reverse-connection loss is effective, i.e. a high-frequency band of 10 MHz or more, and a frequency band in which reverse-connection loss is not effective, i.g. a low-frequency band of several MHz or less.

Accordingly, if the high-frequency band is used, it is necessary that the head end be provided with a repeater and that the transmission of information between communication controllers be carried out through the repeater. In other words, assume that a signal transmitted by a communication controller is an up-signal and that a signal received thereby is a down-signal. By using the repeater to switch the up-signal for the down-signal instead of up- and down-carrier frequencies, a single transmission line will enable communication between communication controllers.

If the low-frequency band is used, on the other hand, the repeater is unnecessary. However, a base band FSK (frequency shift keying) system is employed for signal transmission between communication controllers so that FM and television broadcasts will not be adversely affected. More specifically, when information is transmitted via a television community axial cable by "1", "0" pulses, the pulse signal contains high-frequency components, as a result of which FM and television broadcasts are adversely affected. With the base band FSK system, however, a frequency shift (FS) takes place in a frequency band of several MHz or less in accordance with the "1", "0" information, so that there are no high-frequency components detrimental to FM and television broadcasts.

The present invention is not limited to the above-described embodiments but can be modified in various ways. For example, instead of leading out a conductor from a mesh imbedded in a PC panel, the mesh and an embedded bolt used for connection to the fastener can be electrically connected beforehand at the factory.

Further, in the above-described embodiments, the annular ring and anchor bolt are connected solely on the lower side of the curtain wall. However, a similar connection can be made on the upper side as well. In addition, if the annular ring is affixed to the side face of the PC panel without an intervening insulating layer, the crosswire between the annular ring and anchor bolt can be deleted.

In accordance with the invention, the body of a building is electromagnetically shielded and communication using electric waves of any frequency is carried out inside the building. This enables communication using a wide frequency band and permits communication lines to be increased without limitation. Since the laying of communication cables is unnecessary, building construction is facilitated and construction costs can be reduced. Since an electromagnetic shielding effect is obtained thanks to the mesh imbedded in the PC panels, work on-site is simplified, the term of construction is shortened and expenses are reduced.

The entire external wall surface using curtain walls can be constructed as an electromagnetic shielding layer since an electrically conductive cushion is used as the annular ring wound on the side face of the curtain wall. If an insulating layer is interposed between the electrically conductive cushion and the electromagnetic shielding layer of the curtain wall, the electromagnetic shielding effect of the external wall can still be assured by connecting the electrically conductive cushion and the anchor bolt with the crossover connection wire. Moreover, by connecting the electrically conductive cushion and anchor bolt in advance before construction of the external wall, the latter can be constructed, and the electromagnetic shielding effect can be obtained simultaneously, merely by securing the PC curtain wall to the fastener by means of the anchor bolts, just as in the prior art.

In the communication system, a coaxial cable ordinarily laid in a building is utilized. Leakage coaxial cables and antennas need only be provided on the ceiling of each floor and connected to the aforementioned coaxial cable via branch devices. This reduces the expenses required for the communication medium and eliminates some of the labor involved in construction work. If wireless transceivers are used, communication within the building becomes possible. This makes it unnecessary to modify the partitions and equipment arrangements on each floor as well as the wiring of communication lines when tenants change. The overall result is a very flexible system.

## Claims

1. A method of electromagnetically shielding a building which contains equipment for communication within said building and a signal transmission medium so arranged that sets of said communication equipment communicate with one another within said building by using electric waves
in which an outer peripheral portion of said building is constituted by an electromagnetic shielding structure obtained by constructing an external wall by fixing curtain walls comprising electromagnetic shielding material, to the body of the building by anchor bolts via a metal fastener, affixing an electrically conductive cushion in the form of an annular ring to a side face of each curtain wall so that the ring shaped cushion surrounds the peripheral edge of the curtain wall and is electrically connected with the body of the wall and bringing the annular cushions of adjacent curtain walls into mutually abutting relationship, whereby mutually adjacent curtain walls are electrically integrated and at least a part of the interior of the building is electromagnetically shielded.

2. A method according to Claim 1, wherein an outer peripheral portion of said building is constituted by an electromagnetic shielding structure obtained by constructing a body of the building of ferrite-containing concrete.

3. A method according to Claim 1, wherein an outer peripheral portion of said building is constituted by an electromagnetic shielding structure obtained by constructing a body of the building of mesh-containing concrete.

4. A method according to Claim 1, wherein an outer peripheral portion of said building is constituted by an electromagnetic shielding structure obtained by constructing an external wall of the building of pre-cast panels having an embedded mesh, electrically connecting the meshes in said panels to fixing members of said body, and electrically connecting and grounding panels of upper and lower floors.

5. A method according to Claim 4, wherein conductors led out from the meshes in said panels are connected to the fixing members of said body.

6. A method according to Claim 4 or 5, wherein said fixing members are fasteners.

7. A method according to any preceding Claim, wherein an insulating layer is interposed between said electrically conductive cushion and an electromagnetic shielding layer of the curtain wall, and said cushion and said anchor bolt are electrically connected by a crossover connection wire.

8. A method according to any preceding Claim, wherein a gap between mutually adjacent curtain walls is filled by a back-up member comprising an electromagnetic shielding material, and a caulking material disposed on said back-up member.

9. A method according to any preceding Claim, wherein said signal transmission medium comprises:
a coaxial cable laid so as to pass through each floor of the building, and
leakage coaxial cables or antennas stretched along the ceiling of each floor and connected to said coaxial cable via branching devices.

## Patentansprüche

1. Verfahren zum elektromagnetischen Abschirmen eines Gebäudes mit im Inneren des Gebäudes angeordneten Kommunikationseinrichtungen und einem Signalübertragungsmedium, das so angeordnet ist, daß einzelne Gruppen der Kommunikationseinrichtung miteinander innerhalb des Gebäudes unter Benutzung elektrischer Wellen kommunizieren,
wobei ein äußerer peripherer Abschnitt des Gebäudes durch eine elektromagnetische Abschirmstruktur durch Konstruieren einer Außenwand gebildet ist, durch Befestigen einer Abschirmmauer mit elektromagnetischem Abschirmmaterial am Körper des Gebäudes durch einen Ankerbolzen über ein Metallbefestigungsteil, Befestigen eines elektrisch leitfähigen Puffers in Form eines ringförmigen Rings an der Seitenfläche jeder Abschirmmauer, so daß ein ringförmiger Puffer die periphere Kante der Abschirmmauer umgibt und elektrisch mit dem Körper der Wand verbunden ist und durch Bringen der ringförmigen Puffer benachbarter Abschirmmauern in eine gegenseite Lage, in der sie aneinander anliegen, wodurch wechselseitig aneinanderliegende Abschirmmauern elektrisch integriert sind und wenigstens ein Teil des Inneren des Gebäudes elektromagnetisch abgeschirmt ist.

2. Verfahren nach Anspruch 1, dadurch gekennzeichnet, daß ein äußerer peripherer Teil des Gebäudes durch eine elektromagnetische Abschirmstruktur gebildet ist, die durch Herstellen eines Gebäudeteils aus einem Ferrite enthaltenden Beton erhalten wird.

3. Verfahren nach Anspruch 1, dadurch gekennzeichnet, daß ein peripherer Abschnitt des Gebäudes aus einer elektromagnetischen Abschirmstruktur gebildet ist, die durch Ausbildung eines Gebäudeteils aus einem ein Gitter enthaltenden Beton erhalten wird.

4. Verfahren nach Anspruch 1, dadurch gekennzeichnet, daß ein äußerer peripherer Abschnitt des Gebäudes durch eine elektromagnetische Abschirmstruktur gebildet ist, die man erhält durch Konstruieren einer Außenwand des Gebäudes aus vorgefertigten Tafeln mit eingebettetem Maschengitter, wobei die Maschengitter in den Tafeln mit Befestigungsteilen des Gebäudekörpers elektrisch verbunden werden und die Tafeln der oberen und unteren Decken elektrisch verbunden und geerdet werden.

5. Verfahren nach Anspruch 4, dadurch gekennzeichnet, daß von den Maschengittern in den Tafeln herausgeführte Leiter mit den Fixierteilen des Gebäudekörpers verbunden werden.

6. Verfahren nach Anspruch 4 oder 5, dadurch gekennzeichnet, daß die Fixierteile Befestigungsglieder sind.

7. Verfahren nach einem der vorhergehenden Ansprüche, daduch gekennzeichnet, daß eine Isolierschicht zwischen dem elektrisch leitenden Puffer und einer elektromagnetischen Abschirmschicht der Abschirmmauer angeordnet ist, und daß der besagte Puffer und der besagte Ankerbolzen elektrisch durch einen Kreuzungsverbindungsdraht verbunden sind.

8. Verfahren nach einem der Ansprüche 1 bis 7, dadurch gekennzeichnet, daß eine Lücke zwischen jeweils benachbarten Abschirmwänden durch ein Stützteil ausgefüllt ist, das ein elektromagnetisches Abschirmmaterial enthält, wobei auf dem Stützteil ein Dichtmaterial angeordnet ist.

9. Verfahren nach einem der Ansprüche 1 bis 8, dadurch gekennzeichnet, daß das Signalübertragungsmedium umfaßt:
ein Koaxialkabel, welches so verlegt ist, daß es durch jedes Stockwerk des Gebäudes geführt ist, und
ein Streu-Koaxialkabel oder Antennen, die längs der Decke jedes Stockwerks sich erstrecken und mit dem Koaxialkabel durch Verzweigungseinrichtungen verbunden sind.

## Revendications

1. Procédé pour blinder électromagnétiquement un bâtiment qui contient un équipement pour la communication à l'intérieur dudit bâtiment et un système de transmission de signaux agencé de telle sorte que des groupes dudit équipement de communication communiquent l'un avec l'autre à l'intérieur dudit bâtiment en utilisant des ondes électriques,
dans lequel une portion périphérique extérieure dudit bâtiment est constituée par une structure de blindage électromagnétique obtenue en construisant un mur extérieur en fixant des murs rideaux comprenant un matériau de blindage électromagnétique au corps du bâtiment par des pattes d'ancrage par l'intermédiaire d'un élément de fixation métallique, en fixant un coussin électriquement conducteur sous la forme d'un anneau circulaire sur une face latérale de chaque mur rideau de telle sorte que le coussin en forme d'anneau entoure le bord périphérique du mur rideau et soit électriquement raccordé au corps du mur et en amenant les coussins annulaires de murs rideaux adjacents en relation de butée mutuelle, d'où il résulte que des murs rideaux mutuellement adjacents sont électriquement intégrés et qu'au moins une partie de l'intérieur du bâtiment est électromagnétiquement blindée.

2. Procédé selon la revendication 1, dans lequel une portion périphérique extérieure dudit bâtiment est constituée par une structure de blindage électromagnétique obtenue en construisant un corps du bâtiment en béton contenant une ferrite.

3. Procédé selon la revendication 1, dans lequel une portion périphérique extérieure dudit bâtiment est constituée par une structure de blindage électromagnétique obtenue en construisant un corps du bâtiment en béton contenant un treillis.

4. Procédé selon la revendication 1, dans lequel une portion périphérique extérieure dudit bâtiment est constituée par une structure de blindage électromagnétique obtenue en construisant un mur extérieur du bâtiment en panneaux préfabriqués dans lesquels est noyé un treillis, en raccordant électriquement les treillis dans lesdits panneaux à des éléments de fixation dudit corps, et en raccordant électriquement et en mettant à la terre les panneaux des étages supérieurs et inférieurs.

5. Procédé selon la revendication 4, dans lequel des conducteurs sortant des treillis dans lesdits panneaux sont raccordés aux éléments de fixation dudit corps.

6. Procédé selon la revendication 4 ou la revendication 5, dans lequel lesdits éléments de fixation sont des attaches.

7. Procédé selon l'une des revendications précédentes, dans lequel une couche isolante est interposée entre ledit coussin électriquement conducteur et une couche de blindage électromagnétique du mur rideau, et ledit coussin et ladite patte d'ancrage sont électriquement raccordés par un fil de raccordement croisé.

8. Procédé selon l'une des revendications précédentes, dans lequel un intervalle entre des murs rideaux mutuellement adjacents est rempli par un élément d'appui comprenant un matériau de blindage électromagnétique et un matériau de calfatage disposé sur ledit élément d'appui.

9. Procédé selon l'une des revendications précédentes, dans lequel ledit système de transmission des signaux comprend un câble coaxial posé de façon à passer à travers chaque étage du bâtiment et des câbles coaxiaux de fuite ou des antennes tendus le long du plafond de chaque étage et raccordés audit câble coaxial par l'intermédiaire de dispositifs de branchement.
